# EUROPÄISCHE PATENTSCHRIFT

(11) **EP 0 993 619 B1**
(45) Veröffentlichungstag und Bekanntmachung des Hinweises auf die Patenterteilung: **20.03.2002**
(21) Anmeldenummer: 98941258.0
(22) Anmeldetag: 25.06.1998
(51) Int. Cl.: G01R 33/035

(54) **MAGNETFLUSSSENSOR MIT SCHLEIFENFÖRMIGER SONDE**
MAGNETIC FLUX SENSOR WITH LOOPED PROBE
DETECTEUR DE FLUX MAGNETIQUE AVEC SONDE BOUCLEE

(30) Priorität: 30.06.1997 DE 19727772
(43) Veröffentlichungstag der Anmeldung: 19.04.2000
(73) Patentinhaber: FORSCHUNGSZENTRUM JÜLICH GMBH, 52425 Jülich (DE)
(72) Erfinder: ZHANG, Yi, D-52428 Jülich (DE); HALLING, Horst, D-52459 Inden-Pier (DE); HOHMANN, Rainer, D-52428 Jülich (DE); BOUSACK, Herbert, D-52080 Aachen (DE)
(86) Internationale Anmeldenummer: DE9801798
(87) Internationale Veröffentlichungsnummer: WO9901779

(56) Entgegenhaltungen:
- EP-A- 0 699 921
- US-A- 4 324 255
- US-A- 4 996 621
- US-A- 5 463 518
- US-A- 5 600 243

## Beschreibung

Die Erfindung betrifft einen Magnetflußsensor gemäß dem Oberbegriff des Anspruchs 1.

Aus der Druckschrift DE 195 19 480 A1 ist ein Magnetflußsensor zur Ermittlung einer örtlichen Magnetflußänderung bekannt. Dieser weist eine aus ferromagnetischem Material bestehende Spitze als Sonde sowie einen Supraleitenden Quanten-Interferenzdetektor (SQUID) als Detektor auf.

Der zu ermittelnde Magnetfluß wird über die Sonde zum SQUID geleitet. Der SQUID registriert den magnetischen Fluß und übermittelt ein zugehöriges elektrisches Signal an eine Auswerteelektronik.

Nachteilhaft entspricht die Sonde nicht dem Verlauf eines Magnetfeldes. Ein solches weist nämlich stets geschlossene Feldlinien auf. Die aus DE 195 19 480 A1 bekannte Sonde ist im Unterschied hierzu stabförmig ausgestaltet.

Die Magnetfeldlinien müssen folglich am einen Ende der stabförmigen Sonde ein- und am anderen Ende wieder austreten. Dieser Verlauf hat einen großen magnetischen Widerstand zur Folge.

Damit dennoch ein ausreichend großer magnetischer Fluß durch die Sonde verläuft und so eine genügend hohe Empfindlichkeit gewährleistet ist, muß die Sonde möglichst kurz, d. h. der Abstand zwischen den beiden Sondenenden möglichst gering sein.

Der SQUID befindet sich dann jedoch nachteilhaft nahe beim Meßort. Dies hat zur Folge, daß nicht nur der SQUID, sondern unfreiwillig auch der Meßort gekühlt wird. Daher ist es nicht möglich, eine Messung z. B. bei Raumtemperatur durchzuführen.

Nachteilhaft ist ferner, daß auf engstem Raum sämtliche technischen Spezifikationen realisiert werden müssen. Wird z. B. ein rf-SQUID als Detektor vorgesehen, so ist eine Einkopplung eines elektrischen Wechselfeldes unabhängig vom einzukoppelnden, zu messenden magnetischen Feld in den SQUID aufgrund der beengten räumlichen Verhältnisse praktisch nicht möglich.

Der bekannte Magnetflußsensor reagiert ferner nachteilhaft anfällig gegenüber Störfeldern.

Aus den Druckschrift EP-A-0 699 921 ist ein Magnetflußsensor mit einer schleifenförmigen Sonde und einem Detektor, der einen in der schleifenförmigen Sonde auftretenden magnetischen Fluß zu registrieren vermag, bekannt.

Die US-A-5 463 518 offenbart einen Magnetflußsensor gemäß dem oberbegriff des Anspruchs 1, wobei der SQUID räumlich von einem Meßkopf getrennt ist.

Bei der Druckschrift US-A-4 324 255 ist die Sonde ringförmig ausgebildet, mit Windungen zur Aufnahme eines magnetischen Flusses. Die sonde ist mit einem SQUID räumlich getrennt verbunden. Nachteilig sind die geringe Empfindlichkeit und Ortsauflösung der beschriebenen Magnetflußsensoren.

Aufgabe der Erfindung ist die Schaffung eines empfindlichen Magnetflußsensors, der die im Stand der Technik aufgezeigten Mängel nicht aufweist.

Die Aufgabe wird durch einen Magnetflußsensor mit den Merkmalen des Anspruchs 1 gelöst. Vorteilhafte Ausgestaltungen ergeben sich aus den rückbezogenen Ansprüchen.

Der anspruchsgemäße Magnetflußsensor weist eine schleifenförmige Sonde sowie einen Detektor auf, der den magnetischen Fluß in der Sonde mißt.

Unter schleifenförmiger Sonde im Sinne des Anspruchs ist eine Sonde zu verstehen, bei der die Entfernung zwischen den beiden Enden der Sonde kleiner ist als die Entfernung zwischen einem Ende (der Sonde) und dem Ausleseort des magnetischen Flusses aus der Sonde. Der magnetische Fluß wird z. B. beim aus DE 195 19 480 A1 bekannten Magnetflußsensor an der Stelle der Sonde ausgelesen, die von der Induktionsschleife des SQUIDs umringt wird. Ein Ende der Sonde wird - wie bereits eingangs erläutert - durch den Ein- oder Austritt von Magnetfeldlinien charakterisiert.

Die Schleifenform der anspruchsgemäßen Sonde stimmt mit dem Verlauf von geschlossenen Magnetfeldlinien sehr gut überein. Der magnetische Widerstand wird so gesenkt. Es ist daher möglich, bei gleichbleibender Meßempfindlichkeit die Sonde erheblich zu vergrößern, um so vorteilhaft zu einer großen Distanz zwischen Meßort und Detektor gelangen zu können.

Ein Magnetflußsensor mit den anspruchsgemäßen Merkmalen ist folglich nur geringen räumlichen Beschränkungen unterworfen. Auch ist es als Folge kleiner magnetischer Widerstände möglich, zu größen Empfindlichkeiten der Sonde zu gelangen.

Je geringer die Distanz zwischen den beiden Enden der Sonde ist, um so geringer ist der magnetische Widerstand (bei gleicher Wegstrecke des magnetischen Flusses). Vorteilhaft verbleibt daher nur noch ein Schlitz zwischen den beiden Enden der Sonde. Der Schlitz ist insbesondere nur wenige µm breit.

Die zu registrierenden Magnetfeldlinien treten beim Schlitz in ein Ende der Sonde ein und am anderen Ende aus. Diese Ausführungsform des Magnetflußsensors ermöglicht folglich eine Messung mit sehr hoher Ortsauflösung.

Die Sonde besteht zum Teil aus einem Draht mit einer Permeabilität µ>1, um so weiter zu geringen magnetischen Widerständen zu gelangen.

Als Detektor wird in einer vorteilhaften Ausgestaltung des Verfahrens ein SQUID vorgesehen. Die Sonde wird

durch eine Induktionsschleife des SQUIDs hindurchgeführt und besteht insbesondere aus ferromagnetischem Material.

Es ist somit eine große räumliche Entfernung zwischen der Meßstelle und dem SQUID möglich. Der Meßort kann dann derart weit von der Kühlung des SQUIDs mit flüssigem Stickstoff entfernt sein, daß hier z. B. Raumtemperatur herrscht. Die Erfindung ermöglicht also trotz SQUID das Messen bei frei wählbaren Temperaturen.

Im Unterschied zum Stand der Technik ist weiterhin durch die Anordnung und Abmessung des Schlitzes in der Leiterbahn der Sonde eine sehr hohe Ortsauflösung des Magnetflußsensors gegeben.

In einer vorteilhaften Ausgestaltung der Erfindung kann nun aufgrund des zur Verfügung stehenden Platzes als Detektor unproblematisch ein planares rf-SQUID-Gradiometer eingesetzt werden. Die zwei Induktionsspulen des planaren rf-SQUID-Gradiometers verlaufen gegenläufig, so daß störende Gleichfelder im Detektor kein Störsignal erzeugen können.

Die Sonde wird durch eine Induktionsspule des planaren rf-SQUID-Gradiometers geführt. Das einzukoppelnde rf-Feld wird insbesondere in die andere Induktionsspule und somit räumlich vom Meßsignal getrennt eingekoppelt.

Die Erfindung ermöglicht ferner ein technisch problemloses Vorsehen einer Abschirmung, die den SQUID gegen äußere störende Magnetfelder abschirmt. Diese ist vorzugsweise supraleitend ausgestaltet. Störende Rauscheffekte im SQUID werden durch die supraleitende Ausgestaltung vermieden.

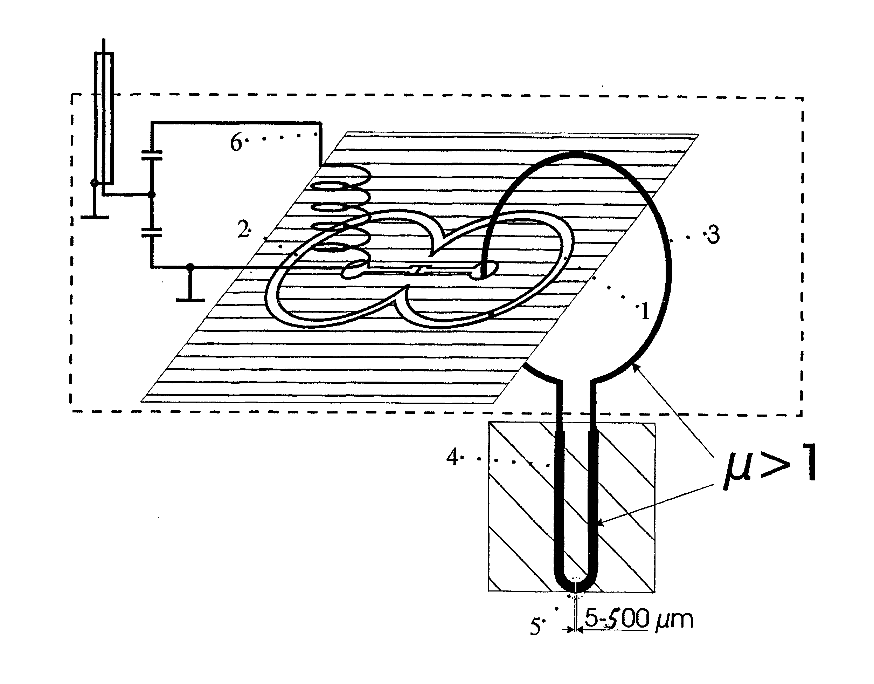

Die Figur verdeutlicht die Ausführungsform mit dem planaren rf-SQUID-Gradiometer. Dargestellt ist ein als Detektor fungierender Chip, auf dem sich ein planares rf-SQUID-Gradiometer mit den zwei Induktionsspulen 1 und 2 befindet. Ein Draht 3 ist zunächst kreisförmig gebogen. Ein Kreisbogen des Drahtes 3 verläuft durch die erste Induktionsspule 1 hindurch. Die beiden Enden des kreisförmig gebogenen Drahtes 3 sind mit einer hochpermeablen Leiterbahn 4 verbunden. Die Leiterbahn 4 befindet sich auf einem Chip. Der Chip mit der Leiterbahn stellt folglich einen Lesekopf dar.

Die Leiterbahn 4 ist durch einen Schlitz 5 unterbrochen. Der Schlitz 5 ist nur wenige µm breit. Die Leiterbahn 4 bildet zusammen mit dem Draht 3 eine schleifenförmige Sonde, die als Ring mit einem U-förmigen Fortsatz ausgebildet ist. In die zweite Induktionsspule 2 wird mittels eines Schwingkreises 6 ein rf-Feld eingekoppelt. Somit geschieht die rf-Einkopplung räumlich getrennt von der Einkopplung des von der Sonde stammenden Signals. Die Kühlung kann auf den durch die gestrichelte Umrandung kenntlich gemachten Bereich beschränkt werden.

Der Magnetflußsensor wird insbesondere in einem Mikroskop eingesetzt.

## Patentansprüche

1. Magnetflußsensor mit einer schleifenförmigen Sonde (3, 4) und einem Detektor, der einen in der schleifenförmigen Sonde (3, 4) auftretenden magnetischen Fluß zu registrieren vermag,
**dadurch gekennzeichnet,**
**daß** die Sonde (3,4) aus einem Draht (3) und einer damit verbundenen, einen Schlitz (5) beinhaltenden Leiterbahn (4) besteht und
**daß** der Schlitz (5) der Leiterbahn (4), bei dem die zu registrierenden Magnetfeldlinien in ein Ende der Sonde eintreten und an deren anderem Ende austreten, maximal 500 µm breit ist, vorzugsweise 10 µm breit ist.

2. Magnetflußsensor nach vorhergehendem Anspruch, **dadurch gekennzeichnet, daß** der Draht (3) der schleifenförmigen Sonde (3, 4) durch eine Induktionsschleife (1) des Detektors führt.

3. Magnetflußsensor nach einem der vorhergehenden Ansprüche, **dadurch gekennzeichnet, daß** der Draht (3) der Sonde (3,4) gebogen ist.

4. Magnetflußsensor nach einem der vorhergehenden Ansprüche, **dadurch gekennzeichnet, daß** der Detektor ein planarer rf-SQUID-Gradiometer (1, 2, 6) ist.

5. Mikroskop umfassend einen Magnetflußsensor nach einem der Ansprüche 1 bis 4.

## Claims

1. Magnetic flux sensor having a looped probe (3, 4) and a detector which is able to register a magnetic flux appearing in the looped probe (3, 4),
**characterised in that** the probe (3, 4) consists of a wire (3) and a printed conductor (4) which is connected thereto and comprises a slot (5), and that the slot (5) of the printed conductor (4), in which the magnetic lines of force to be registered enter at one end of the probe and exit at the other end thereof, is not more than 500 µm wide and is preferably 10 µm wide.

2. Magnetic flux sensor according to the preceding claim, **characterised in that** the wire (3) of the looped probe (3, 4) runs through an induction loop (1) of the detector.

3. Magnetic flux sensor according to either of the preceding claims, **characterised in that** the wire (3) of the probe (3, 4) is curved.

4. Magnetic flux sensor according to any of the preceding claims, **characterised in that** the detector is a planar rf SQUID gradiometer (1, 2, 6).

5. Microscope incorporating a magnetic flux sensor according to any of claims 1 to 4.

## Revendications

1. Détecteur de flux magnétique ayant une sonde (3, 4) en forme de boucle et un détecteur qui permet d'enregistrer un flux magnétique se produisant dans la sonde (3, 4) en forme de boucle, **caractérisé**
**en ce que** la sonde (3, 4) est constituée d'un fil (3) métallique et d'une piste (4) conductrice qui y est reliée et qui comporte une fente (5) et en ce que la fente (5) de la piste (4) conductrice, dans laquelle les lignes du champ magnétique à enregistrer entrent à une extrémité de la sonde et sortent à son autre extrémité, a une largeur au maximum de 500 µm et, de préférence, a une largeur de 10 µm.

2. Détecteur de flux magnétique suivant la revendication précédente, **caractérisé en ce que** le fil (3) métallique de la sonde (3, 4) en forme de boucle passe dans une boucle (1) d'induction du détecteur.

3. Détecteur de flux magnétique suivant l'une des revendications précédentes, **caractérisé en ce que** le fil (3) métallique de la sonde (3, 4) est recourbé en forme d'anneau.

4. Détecteur de flux magnétique suivant l'une des revendications précédentes, **caractérisé en ce que** le détecteur est un gradiomètre (1, 2, 6) planaire à SQUID rf.

5. Microscope comprenant un détecteur de flux magnétique suivant l'une des revendications 1 à 4.
